# EUROPÄISCHE PATENTSCHRIFT

(11) **EP 0 719 309 B1**
(45) Veröffentlichungstag und Bekanntmachung des Hinweises auf die Patenterteilung: **02.12.1998**
(21) Anmeldenummer: 94927529.1
(22) Anmeldetag: 01.09.1994
(51) Int. Cl.: C09K 11/06, H05B 33/14

(54) **VERWENDUNG VON POLYMEREN MIT ISOLIERTEN CHROMOPHOREN ALS ELEKTROLUMINESZENZMATERIALIEN**
USE OF POLYMERS WITH ISOLATED CHROMOPHORES AS ELECTROLUMINESCENT MATERIALS
UTILISATION DE POLYMERES PRESENTANT DES CHROMOPHORES ISOLES COMME MATERIAUX ELECTROLUMINESCENTS

(30) Priorität: 15.09.1993 DE 4331401
(43) Veröffentlichungstag der Anmeldung: 03.07.1996
(73) Patentinhaber: HOECHST AKTIENGESELLSCHAFT, 65929 Frankfurt am Main (DE)
(72) Erfinder: STERN, Roland, D-65189 Wiesbaden (DE); SCHENK, Hermann, D-65719 Hofheim (DE); SALBECK, Josef, D-65779 Kelkheim (DE); STEHLIN, Thomas, D-65830 Kriftel (DE); SCHERF, Ullrich, D-55252 Mainz (DE); MÜLLEN, Klaus, D-55128 Mainz (DE); LEISING, Günther, A-8042 Graz (AT)
(86) Internationale Anmeldenummer: EP9402899
(87) Internationale Veröffentlichungsnummer: WO9507955

(56) Entgegenhaltungen:
- WO-A-94/15441
- JOURNAL OF APPLIED PHYSICS, Bd.74, Nr.5, 1. September 1993, USA Seiten 3584 - 3586 I.SOKOLIK & AL 'blue-light electroluminescence from p-phenylene vinylene-based copolymers'

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Neben anorganischen sind seit etwa 30 Jahren auch organische Elektrolumineszenzmaterialien und -vorrichtungen bekannt (siehe z.B. US-A-3,172,862). Bis vor kurzem waren aber solche Vorrichtungen in ihrer praktischen Verwendbarkeit stark eingeschränkt.

In WO 90/13148 und EP-A 0 443 861 sind Elektrolumineszenzvorrichtungen beschrieben, die einen Film aus einem konjugierten Polymer als lichtemittierende Schicht (Halbleiterschicht) enthalten. Solche Vorrichtungen bieten im Vergleich zu den bisher bekannten zahlreiche Vorteile, wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.

Eine typische Vorrichtung nach WO 90/13148 besteht aus einer lichtemittierenden Schicht in Form eines dünnen, dichten Polymerfilms (Halbleiterschicht), der wenigstens ein konjugiertes Polymer enthält. Eine erste Kontaktschicht steht in Kontakt mit einer ersten Oberfläche , eine zweite Kontaktschicht mit einer weiteren Oberfläche der Halbleiterschicht. Der Polymerfilm der Halbleiterschicht hat eine genügend geringe Konzentration von extrinsischen Ladungsträgern, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere sind konjugiert. Unter konjugiertem Polymer versteht man ein Polymer, das ein delokalisiertes π-Elektronensystem entlang der Hauptkette besitzt. Das delokalisierte π-Elektronensystem verleiht dem Polymer Halbleitereigenschaften und gibt ihm die Möglichkeit positive und/oder negative Ladungsträger mit hoher Mobilität zu transportieren. Eine Übersicht über konjugierte Polymere ist beispielsweise bei R.H. Friend, J. Mol. Elec. 4 (1988) 37, zu finden.

In WO 90/13148 und EP-A 0 443 861 wird als polymeres Material für die lichtemittierende Schicht Poly(p-phenylenvinylen) verwendet, und es wird vorgeschlagen, die Phenylgruppe in einem solchen Material durch ein heterocyclisches oder ein kondensiertes carbocyclisches Ringsystem zu ersetzen.

Obwohl mit diesen Materialien gute Ergebnisse erzielt wurden, ist z.B. die Farbreinheit noch unbefriedigend. Weiterhin ist es mit den bisher bekannt gewordenen Polymeren kaum möglich, eine blaue oder weiße Emission zu erzeugen.

In Polymer Preprints 34 (1993) 532 sind Strukturen beschrieben, bei denen einzelne, direkt verbundene Chromophorsegmente gegeneinander verdrillt sind, um eine Blauverschiebung der Emission zu erreichen. Jedoch ist nach Angaben der Verfasser die Herstellung von lichtemittierenden Dioden aus diesen Materialien nicht möglich.

Die vorliegende Erfindung hat die Aufgabe, konjugierte Polymermaterialien bereitzustellen, mit denen die oben beschriebenen Nachteile zumindest teilweise behoben werden.

Es wurde nun gefunden, daß sich insbesondere die Farbreinheit der Emission konjugierter Polymere deutlich verbessert, wenn deren Emissionseigenschaften überwiegend durch die Emissionseigenschaften einzelner Chromophore bestimmt werden. Das heißt, daß die Chromophore dieser Polymere in Bezug auf die Emissionsspektren entkoppelt sind.

Gegenstand der Erfindung ist daher die Verwendung eines Polymers, enthaltend konjugativ verknüpfte Chromophorsegemente und Spacersegmente, dessen Emissionseigenschaften durch die Emissionseigenschaften der einzelnen Chromophorsegemente bestimmt werden, in elektrooptischen Schalt- und Anzeigevorrichtungen.

Elektrolumineszenzvorrichtungen, die solche Polymere enthalten, zeichnen sich unter anderem durch eine hohe Farbreinheit aus. Mit den erfindungsgemäß verwendeten Polymeren lassen sich insbesondere auch blaue und weiße Elektrolumineszenz erzielen.

Unter Konjugation wird im Sinne der Erfindung verstanden, wenn mindestens drei sp²-hybridisierte Atome in einer Reihe direkt aneinander gebunden sind.

Unter Emissionseigenschaften wird im Sinne der Erfindung die Leuchtcharakteristik der lichtemittierenden Schichten bezüglich der Lichtintensität, spektralen Verteilung und der Lichtausbeute, bezogen auf die angelegte Spannung oder die Intensität des eingestrahlten Lichtes, verstanden.

Die Bestimmung der Emissionseigenschaften des Polymers durch die Emissionseigenschaften der Chromophorsegmente bedeutet, daß die Emission des Polymers im wesentlichen der der isolierten Chromophore entspricht. Das heißt, daß die Emissionsmaxima des Polymers und des isolierten Chromophors nicht mehr als 30 nm voneinander abweichen.

Vorteilhafterweise sind bei den erfindungsgemäß verwendeten konjugierten Polymere, deren Emissionseigenschaften durch die Emissionseigenschaften der einzelnen Chromophorsegmente bestimmt werden, einzelne Chromophor- und Spacersegmente gegeneinander verdrillt.

Vorzugsweise beträgt der Verdrillungswinkel der Einzelsegmente gegeneinander 10° bis 170°, besonders bevorzugt 30° bis 150°, ganz besonders bevorzugt 60° bis 120°.

Unter Spacersegment wird im Sinne der Erfindung eine Gruppe verstanden, deren Absorption kürzerwellig als die des Chromophorsegments ist. Da damit der Abstand zwischen dem höchsten besetzten und dem niedrigsten unbesetzten Molekülorbital (Bandlücke) des Chromophorsegments kleiner als der des Spacers ist, werden die Emissionseigenschaften des Polymers durch die Emissionseigenschaften der Chromophorsegmente bestimmt.

Vorzugsweise ist die Absorption der Spacersegmente mindestens 25 nm kürzerwellig als die der Chromophorsegmente, besonders bevorzugt 25 bis 100 nm kürzerwellig.

Die Chromophorsegmente weisen vorzugsweise eine Absorption im Bereich von 300 - 1150 nm und eine Emission im Bereich von 380 - 1200 nm auf. Besonders bevorzugt als Chromophorsegmente sind methylenverbrückte, planare Oligophenylene oder Heterocyclen.

Ganz besonders bevorzugte Chromophorsegmente sind solche der allgemeinen Formel (Ia) bis (Ij), 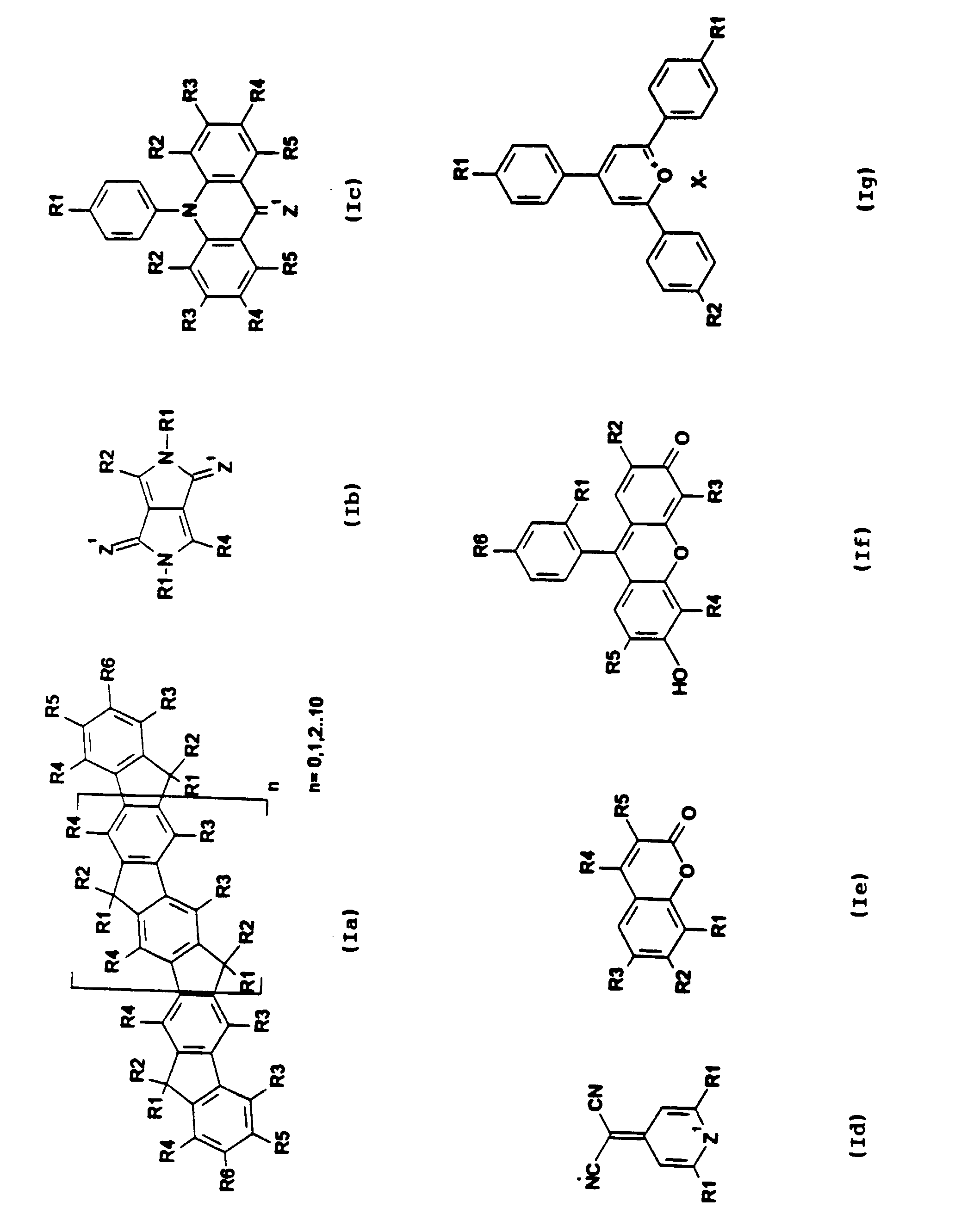 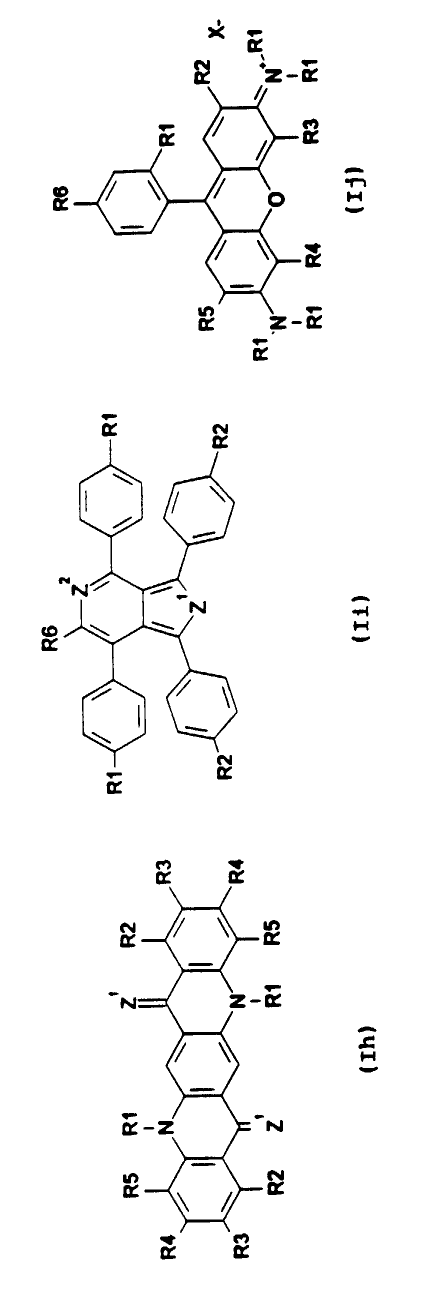 worin die Symbole bedeuten:
- R¹: H, eine geradkettige oder verzweigte Alkylgruppe mit 1 bis 22 C-Atomen, eine C₆-C₁₀-Arylgruppe oder die Verknüpfungsstelle zum benachbarten Spacersegment, wobei die Verknüpfung so sein muß, daß die Konjugation erhalten bleibt;
- R², R³, R⁴, R⁵, R⁶: R¹ gleich oder verschieden eine geradkettige oder verzweigte Alkoxygruppe mit 1 bis 22 C-Atomen, C₆-C₁₀-Aryloxy, NR¹₂, NO₂, CN;
- Z¹: O, S, NR¹, CR²₂;
- Z², Z³: CR², N;
- X⁻: Cl^{⊖}, Br^{⊖}, I^{⊖}, BF^{⊖}₄, PF^{⊖}₆, B(Ph)₄^{⊖};
- n: 1, 2, 3, 4, 5.

Bevorzugt sind Chromophorsegmente der Formel (Ia).

Beispiele für bevorzugte Spacersegmente sind solche der Formeln (IIa) bis (IIv): 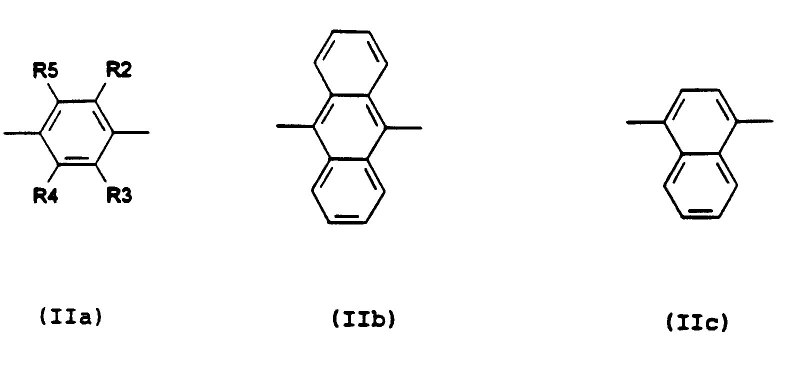 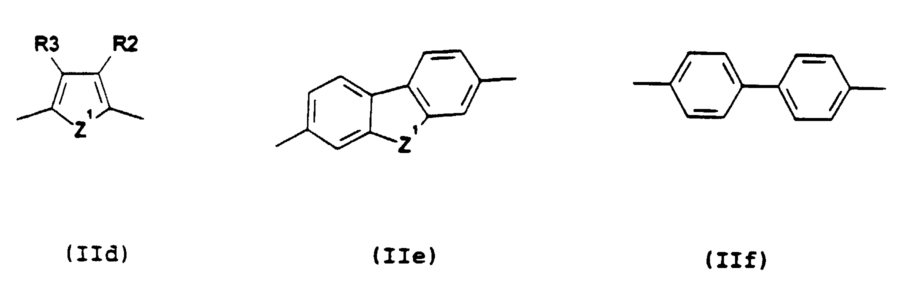 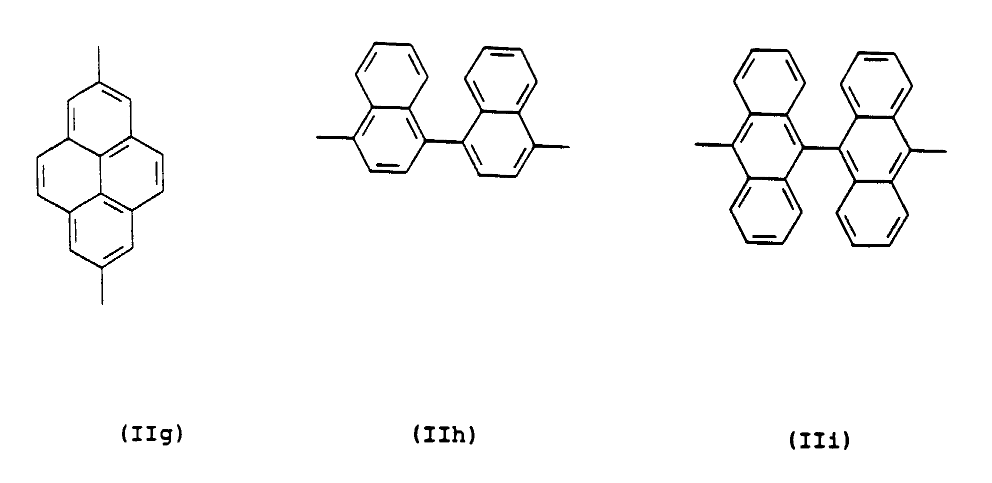 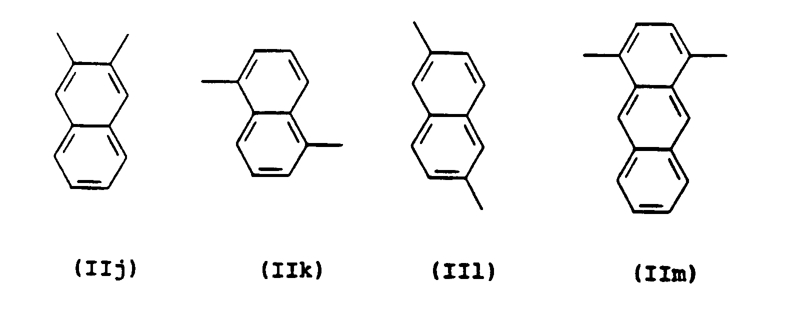 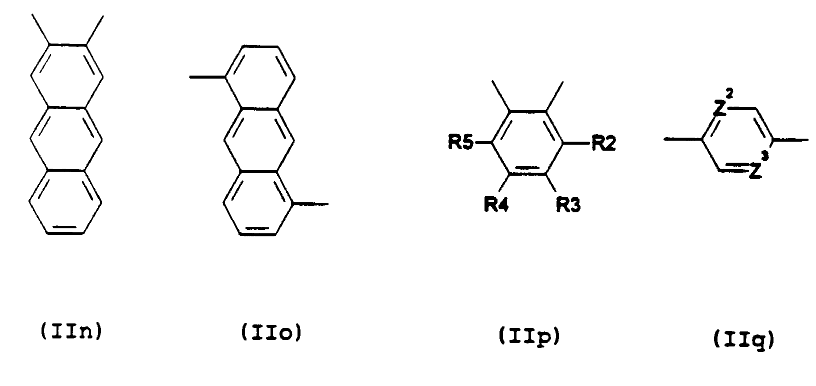 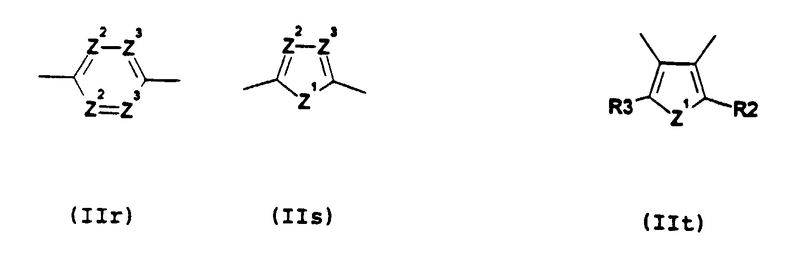 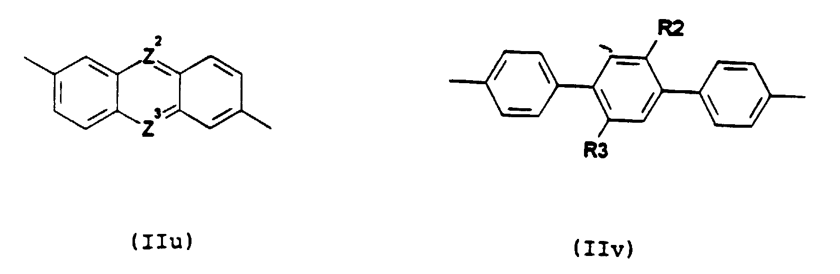 wobei Z¹, Z², Z³, R², R³, R⁴, R⁵ die in der Formel (I) angegebenen Bedeutungen haben.

Die erfindungsgemäß verwendeten Polymere sind Copolymere aus einer oder mehreren Chromophorgruppen mit einer oder mehreren Spacergruppen. Bevorzugt sind Strukturen bei denen eine alternierende Abfolge von Chromophor- und Spacergruppen realisiert ist.

Vorzugsweise enthalten die erfindungsgemäß verwendeten Polymere Chromophorsegmente der Formeln (Ia) bis (Ij) und Spacersegmente der Formeln (IIa) bis (IIv).

Die erfindungsgemäß verwendeten Polymere sind teilweise bekannt und teilweise neu. Gegenstand der Erfindung ist daher auch ein Polymer, enthaltend Struktureinheiten gemäß mindestens einer der Formeln (Ia) bis (Ij) und Struktureinheiten gemäß mindestens einer der Formeln (IIa) bis (IIv). Bevorzugt ist ein Polymer, enthaltend Chromophorsegmente der Formel (la) und Spacersegmente gemäß mindestens einer der Formeln (lla) bis (lle). Ganz besonders bevorzugt ist ein Polymer, enthaltend Chromophorsegmente der Formel (Ia) und Spacersegmente gemäß mindestens einer der Formeln (IIa) bis (IIc).

Erfindungsgemäß eingesetzte Polymere sind vorrangig auf zwei Syntheserouten herstellbar.
1. Die erste Route beinhaltet die chemische Kupplung geeignet substituierter Chromophorsegmente zu Polymeren der erfindungsgemäßen Strukturen. Dabei werden die Chromophorsegmente mittels geeigneter Spacersegmente konjugativ verbunden. Durch die verwendeten Spacersegmente ist es wiederum möglich, über die Wahl der Spacerstruktur definiert den Verdrillungswinkel zwischen den Chromophorsegmenten einzustellen. Als Spacersegmente kommen dabei vor allem Arylene, wie 1,4-Phenylen, 2,5-disubstituierte 1,4-Phenylen-, 1,4- und 1,5-Naphthylen, 1,4- und 9,10-Anthrylen-Bausteine (sowie die entsprechenden heteroaromatischen Analoga), in Frage, desweiteren auch mono- oder disubstituierte Vinylen-Einheiten, wobei als Substituenten der Arylen- und Vinylensegemente Alkyl-, Aryl-, Alkoxy- und Aryloxy-Gruppen bevorzugt sind. Die chemische Kupplung zwischen den Chromophorsegmenten mittels der angeführten Spacergruppen erfolgt, dann über funktionelle Gruppen (wobei auch -H als funktionelle Gruppe wirken kann), mit denen die vorgeformten Chromophor- und Spacersegmente ausgestattet sind. Hierbei finden Methoden zur Aryl-Aryl- und Aryl-Olefin-Verknüpfung Anwendung. Literaturbekannte Methoden dazu sind unter anderem:
   - Übergangsmetall-katalysierte Kupplungen vom HECK-Typ [siehe z.B. Heck, R.F.; Org. Reactions (1981)
      27 345], YAMAMOTO-Typ [siehe z.B. Yamamoto, T.; Prog. Polym. Sci. 1153], SUZUKI-Typ [siehe z.B. Miyaura, N., Yanagi, T., Suzuki, A.; Synth. Commun. (1981)
      11 513] und STILLE-Typ [siehe z.B. Stille, J.K.; Angew. Chem. (1986)
      98 504, Int. Ed. Engl. (1986)
      25 508], sowie andere wohlbekannte Kupplungsmethoden [siehe z.B. HOUBEN-WEYL, Methoden der Organischen Chemie, Band
      5/2b "Arene, Arine", Thieme, Stuttgart, 1981].
   - Oxydative Aryl-Aryl-Kupplungen, wie die SCHOLL-Reaktion [siehe z.B. Scholl, R., Seer, C.; Ann. (1912)
      394 111] oder die oxidative Kupplung elektronenreicher Heteroaromaten, wie Thiophen oder Pyrrol.
   - Carbonylolefinierungsreaktionen vom WITTIG-, HORNER-EMMONS- oder McMURRY-Typ [siehe z.B. HOUBEN-WEYL, Methoden der Organischen Chemie, Band 5/1b "Alkene, Cycloalkene, Arylalkene", Thieme, Stuttgart 1972], oder die reduktive Verknüpfung geeigneter Carbonylderivate (α,α'-Dihalogenverbindungen, Thioketone, Diazoketone) [siehe z.B. HOUBEN-WEYL, Methoden der Organischen Chemie, Band 5/1b "Alkene, Cycloalkene, Aralkene", Thieme, Stuttgart 1972].
2. Die zweite Route beinhaltet die Synthese geeigneter Präpolymere im ersten Schritt, gefolgt von einer polymeranalogen Erzeugung der gewünschten, erfindungsgemäßen Struktur. Dies geschieht durch Mischen geeigneter Monomere, die zumindest potentiell die späteren Strukturbestandteile (Chromophor- und Spacersegmente) repräsentieren. Die Copolymerisation (Cokondensation) der aromatischen und/oder olefinischen Monomere führt zu einem Copolymer mit statistischer Verteilung der Monomerbausteine. Die Kupplung der Monomerbausteine erfolgt hierbei beispielsweise mittels der oben aufgelisteten Methoden zur Aryl-Aryl- bzw. Aryl-Olefin-Kupplung. Der Aufbau der Zielstrukturen geschieht dann mittels eines polymeranalogen Reaktionsschrittes unter Aufbau der erfindungsgemäßen Chromophorsegmente. Hierbei finden insbesondere Reaktionen, die zu einer Verbrückung vorhandener Monomersegmente unter Ausbildung hochkondensierter, planarer Substrukturen führen, Anwendung. Dies geschieht bevorzugt durch intramolekulare Kondensations-(Cyclisierungs-)reaktionen vom FRIEDEL-CRAFTS-Typ (Alkylierung, Acylierung [vergleiche z.B. DE-A 41 11 878], Elektronentransferinduzierte Cyclisierungsreaktionen (reduktive und oxidative Kondensation [vergleiche z.B. U. Scherf, K. Müllen; Synthesis (1992) 23]), diverse Carbonylolefinierungsreaktionen (wie z.B. oben aufgeführt) oder mittels photochemischer Cyclisierungen (Kondensationen).

Beispielhaft ist die Synthese eines erfindungsgemäßen Polymers in Schema 1 dargestellt.

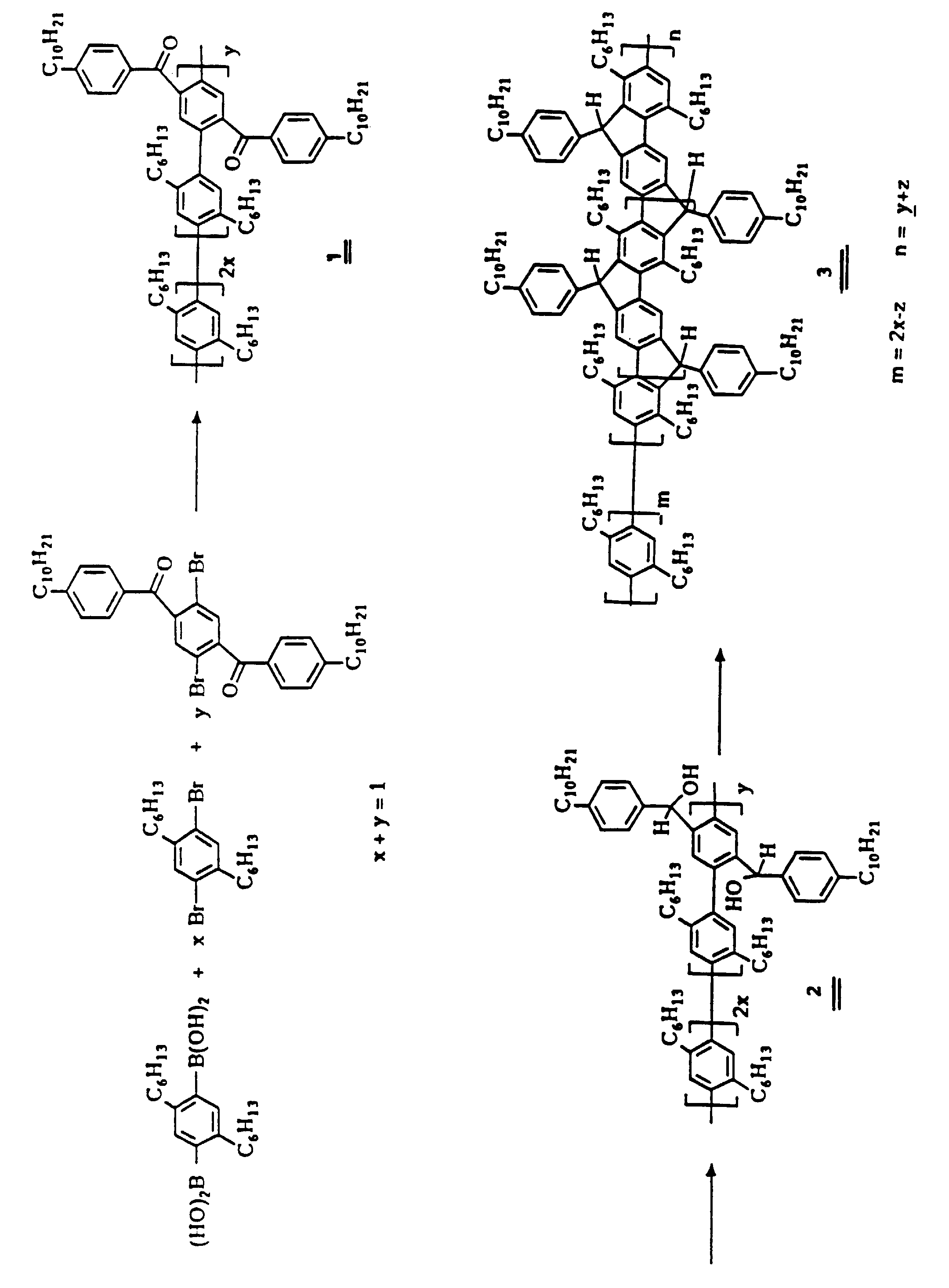

Erfindungsgemäß werden die aufgeführten Polymere in elektrischen, elektronischen und elektrooptischen Bauteilen verwendet. Bevorzugt ist die Verwendung in elektrooptischen Schalt- und Anzeigevorrichtungen, insbesondere solchen, die auf der Elektrolumineszenz beruhen. Besonders bevorzugt ist die Verwendung in Vorrichtungen, wie sie beispielsweise in WO 90/13148 und EP-A 0 443 861 beschrieben sind. Gegenstand der Erfindung sind auch elektrooptische Schalt- und Anzeigevorrichtungen, enthaltend ein vorstehend beschriebenes Polymer.

Die Erfindung wird durch die Beispiele näher erläutert, ohne sie darauf beschränken zu wollen.

### Beispiele

### Beispiel 1

Synthesevorschrift von

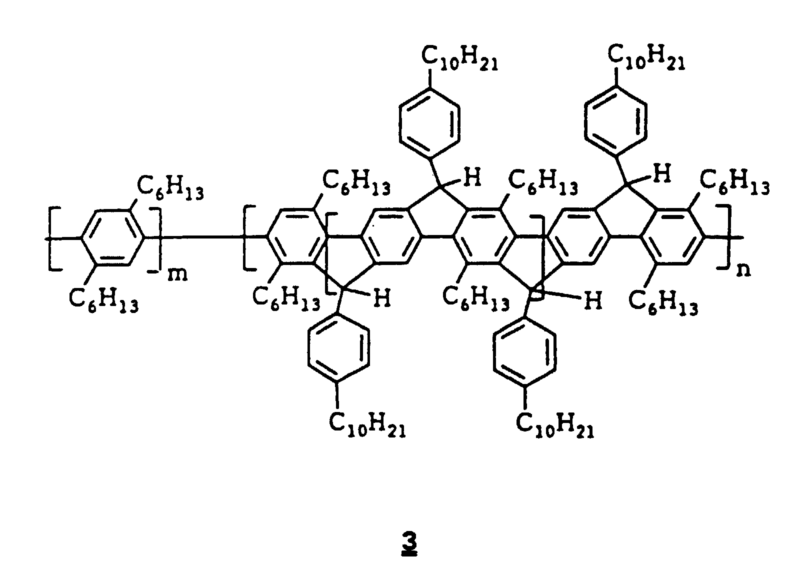

Copolymer mit m = 0,60 und n = 0,40 (siehe auch Schema 1)
1. 0,363 g 4,4"-Didecyl-2',5'-dibrom-terephthalophenon (0,5 mmol), 0,202 g 2,5-Dihexyl-1,4-dibrombenzol (0,5 mmol) und 0,334 g 2,5-Dihexyl-1,4-phenylendiboronsäure (1 mmol) werden in 5 ml Toluol gelöst und unter Inertbedingungen zu 5 ml 2N wäßriger Natriumcarbonatlösung gegeben. Die Mischung wird zum Rückfluß erhitzt; sodann werden 30 mg Tetrakis(triphenylphosphin)-palladium(0) (0,026 mmol) in 5 ml Toluol und 5 ml n-Butanol zugegeben. Nach 24 h am Rückfluß wird das gebildete Polymer durch Eingießen in Methanol gefällt, sauer gewaschen und in wenig Toluol aufgenommen. Trocknen der Lösung, Einengen und Acetonfällung liefern 535 mg (83 %) 1.
2. 200 mg 1 (O,309 mmol) in 20 ml Toluol werden zu 70 mg Lithiumaluminiumhydrid (1,84 mmol, aufgeschlämmt in 20 ml THF) zugetropft. Nach 30 min. Rühren bei Raumtemperatur wird vorsichtig mit 2N-Salzsäure zersetzt und mit Wasser gewaschen. Die organische Phase wird getrocknet und zur Trockne eingeengt. Sodann wird Polymer 2 in wenig THF aufgenommen und in Wasser ausgefällt. Ausbeute 167 mg (84 %) 2.
3. 163 mg (0,250 mmol) 2 werden in 50 ml Methylenchlorid gelöst und mit 100 mg Bortrifluorid-Etherat (0,700 mmol) versetzt. Nach 5 min werden 20 ml Ethanol, gefolgt von 50 ml Wasser eingerührt. Die organische Phase wird sorgfältig säurefrei gewaschen, getrocknet und eingeengt. Die Ausfällung in Aceton ergibt 138 mg (85 %) 3 als hellgelbes, intensiv blau fluoreszierendes Pulver. Die mittels GPC bestimmten Molekulargewichte (mit Polystyrol als Standard, o-Dichlorbenzol als Lösungsmittel) betragen: Mₙ = 8000, M_{w} = 15500. Das Emissionsspektrum zeigt zwei Maxima bei 454 nm und 480 nm. Die Halbwertsbreite der gesamten Emission beträgt 60 nm (siehe auch Figur 1).

### Beispiel 2

Synthesevorschrift von 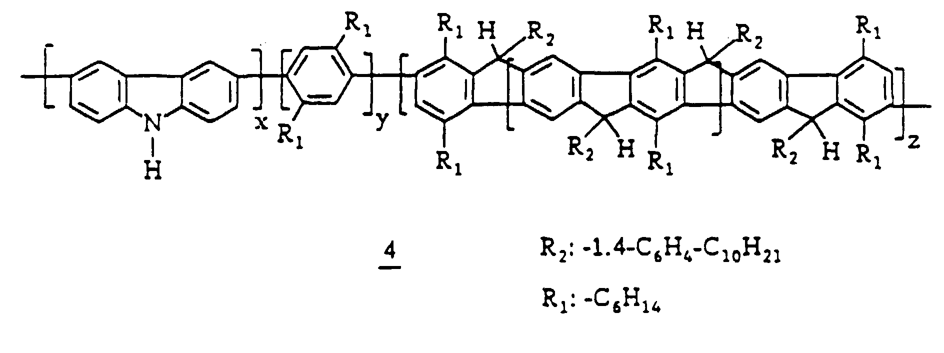 0,290 g 4,4"-Dodecyl-2',5'-dibrom-terephthalophenon (0,4 mMol), 0,121 g 2,5-Dihexyl-1,4-dibrombenzol (0,3 mMol), 97,5 mg 3,6-Dibromcarbazol (0,3 mMol) und 0,334 g 2,5-Dihexyl-1,4-phenylendiboronsäure (1 mMol) werden in Analogie zu Beispiel 1 zur Reaktion (Reaktionsschritte 1 bis 3) gebracht. Ausbeute nach dem 3. Schritt: 303 mg Copolymer 4; Mₙ: 4100; M_{w}: 6200 (GPC in 1,2-Dichlorbenzol, Eichung mit Polystyrol (PS)-Standards) als gelblich gefärbtes Pulver.

### Beispiel 3

Synthesevorschrift von 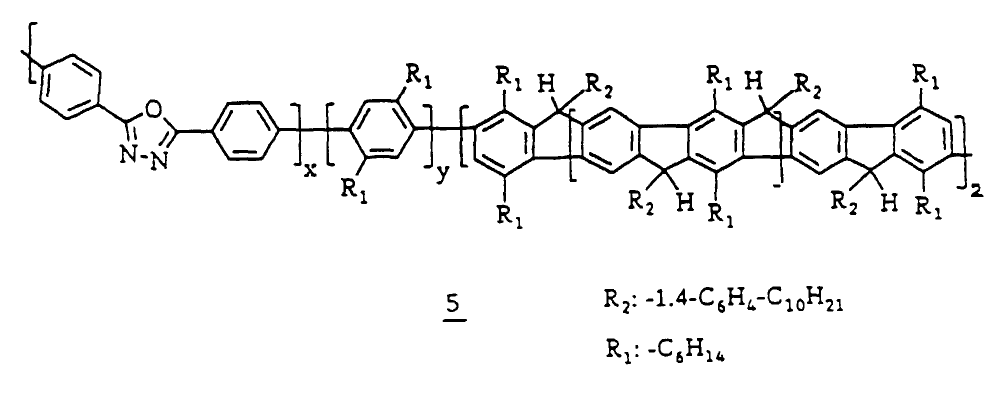 0,290 g 4,4"-Dodecyl-2'.5'-dibrom-terephthalophenon (0,4 mMol), 0,121 g 2,5-Dihexyl-1,4-dibrombenzol (0,3 mMol), 0,114 g 2,5-Bis(4-bromphenyl)-1,3,4-oxadiazol (0,3 mMol) und 0,334 g 2,5-Dihexyl-1,4-phenylendiboronsäure (1 mMol) werden in Analogie zu Beispiel 1 zur Reaktion (Reaktionschritte 1 bis 3) gebracht.
Ausbeute nach dem 3. Schritt: 372 mg Copolymer 5; Mₙ: 18000; M_{w}: 31000 (GPC in 1,2-Dichlorbenzol, Eichung mit PS-Standards) als schwach hellgelb gefärbtes Pulver.

### Beispiel 4

### Elektrolumineszenzvorrichtung mit 60/40 Copolymer 3 aus Beispiel 1 als Elektrolumineszenzschicht

Das nach Beispiel 1 synthetisierte Copolymer 3 wird in Chloroform gelöst (30 mg/ml) und mittels Spin-coating (1000-3000 rpm) auf einen, partiell mit elektrisch leitfähigem Indium/Zinn-Oxid (ITO) beschichteten, Glasträger aufgebracht, wobei ein homogener transparenter Film mit einer Dicke von 150-250 nm (gemessen mit DekTak-II Schichtdickenmeßgerät) gebildet wird. Auf diesen Film wird durch Vakuumbedampfung eine zweite Elektrode aus Calcium aufgebracht. Beim Anlegen einer elektrischen Spannung zwischen der ITO-Elektrode und der Metallelektrode, wobei die Metallelektrode negativ gegenüber der ITO-Elektrode gepolt ist, wird hellblaue Elektrolumineszenz beobachtet. Die ermittierende Fläche der Elektrolumineszenzvorrichtung beträgt 5 mm² und wird definiert durch die Überlappung der ITO-Elektrode und der Calciumelektrode. Die Intensität der Elektrolumineszenz steigt linear mit dem Strom und die interne Quanteneffizienz ist konstant bei Stromdichten über 0,8 mA/cm².
Alle Verarbeitungsschritte und Messungen werden unter Intertbedingungen durchgeführt. Die interne Quanteneffizienz der Elektrolumineszenz wird unter Berücksichtigung von Korrekturen für die Emissionscharakteristik, den Öffnungswinkel des Detektors, das Streulicht und die Verluste im Substrat berechnet.

## Patentansprüche

1. Verwendung eines Copolymers, enthaltend konjugativ verknüpfte Chromophor- und Spacersegmente, wobei die Absorption der Spacersegmente mindestens 25 nm kürzerwellig ist als die der Chromophorsegmente und wobei die Emissionseigenschaften des Polymers durch die Emissionseigenschaften der einzelnen Chromophorsegmente bestimmt wird, in elektrooptischen Schalt- und Anzeigevorrichtungen.

2. Verwendung nach Anspruch 1, dadurch gekennzeichnet, daß einzelne Segmente des Polymers gegeneinander verdrillt sind.

3. Verwendung nach Anspruch 1 oder 2, dadurch gekennzeichnet, daß der Verdrillungswinkel 10° bis 170° beträgt.

4. Verwendung nach einem oder mehreren der Ansprüche 1 bis 3, dadurch gekennzeichnet, daß das Polymer eine alternierende Abfolge von Chromophor- und Spacergruppen aufweist.

5. Verwendung nach einem oder mehreren der Ansprüche 1 bis 4, dadurch gekennzeichnet, daß das Polymer Chromophorsegmente nach mindestens einer der Formeln (Ia) bis (Ij) enthält: 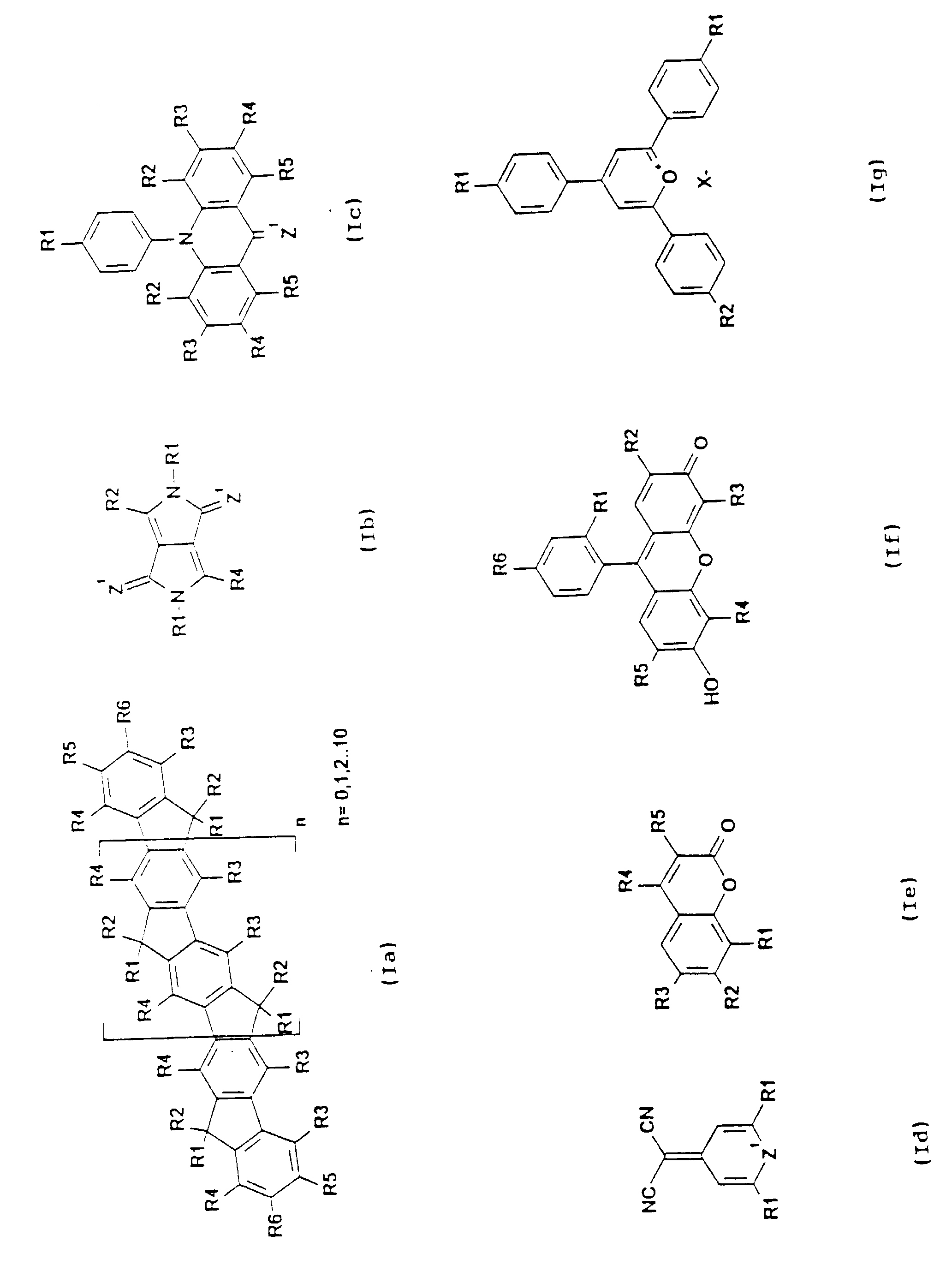 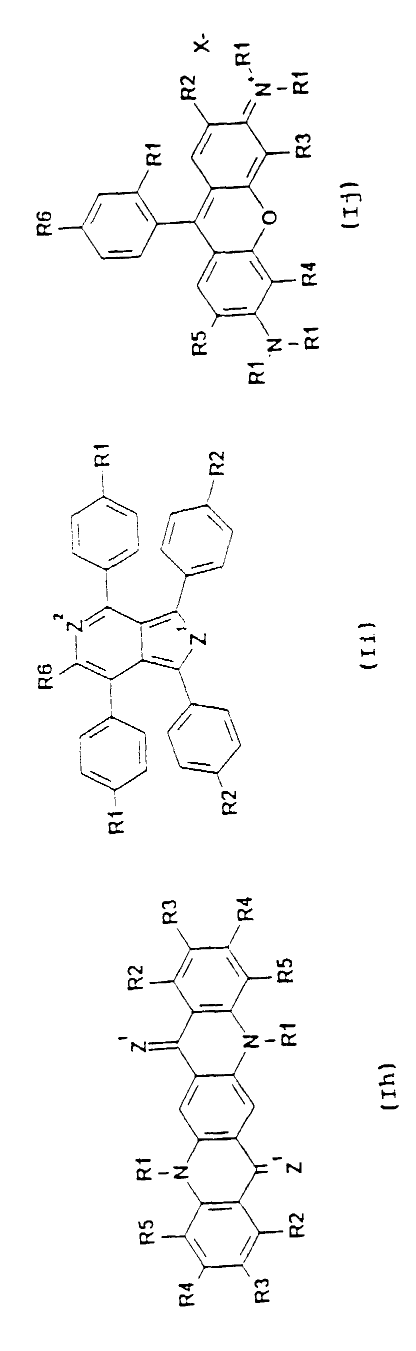 worin die Symbole bedeuten:
R¹ H, eine geradkettige oder verzweigte Alkylgruppe mit 1 bis 22 C-Atomen, eine C₆-C₁₀-Arylgruppe oder die Verknüpfungsstelle zum benachbarten Spacersegment, wobei die Verknüpfung so sein muß, daß die Konjugation erhalten bleibt;
R², R³, R⁴, R⁵, R⁶ R¹ gleich oder verschieden eine geradkettige oder verzweigte Alkoxygruppe mit 1 bis 22 C-Atomen, C₆-C₁₀-Aryloxy, NR¹₂, NO₂, CN;
Z¹ O, S, NR¹, CR²₂;
Z², Z³ CR², N;
X⁻ Cl^{⊖} , Br^{⊖}, I^{⊖}, BF^{⊖}₄, PF^{⊖}₆, B(Ph)₄^{⊖};
n 1, 2, 3, 4, 5.

6. Verwendung nach einem oder mehreren der Ansprüche 1 bis 5 dadurch gekennzeichnet, daß das Polymer Spacersegmente gemäß mindestens einer der Formeln (IIa) bis (IIv) enthält: 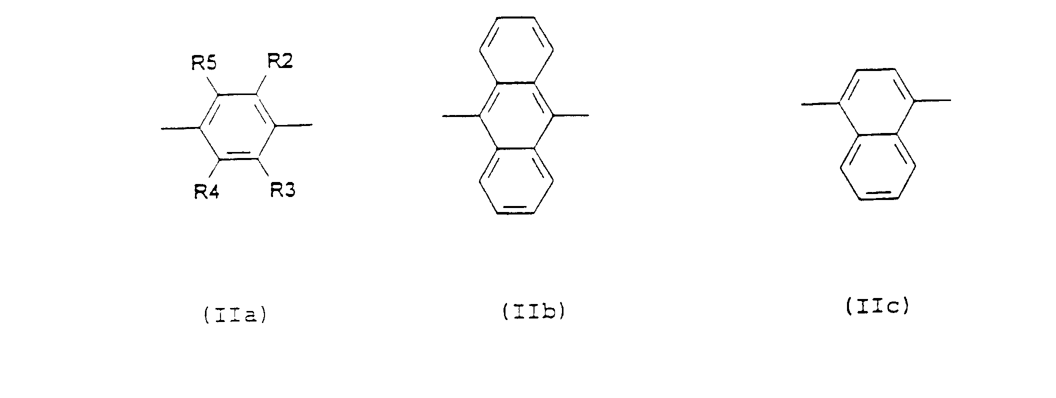 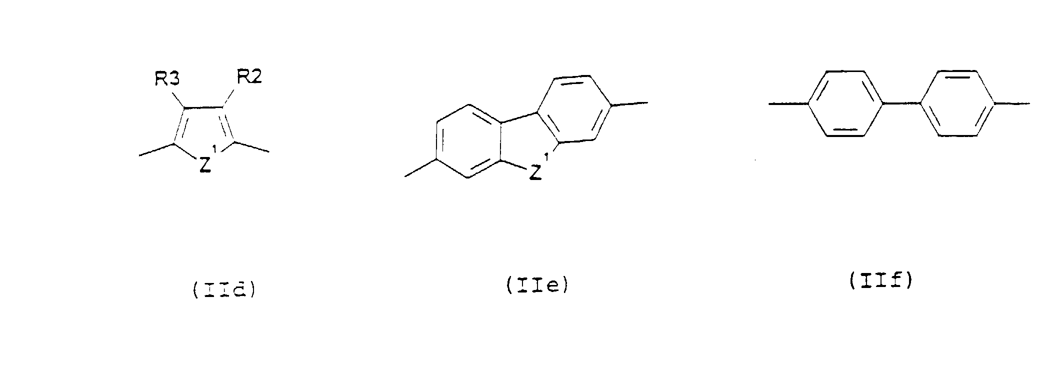 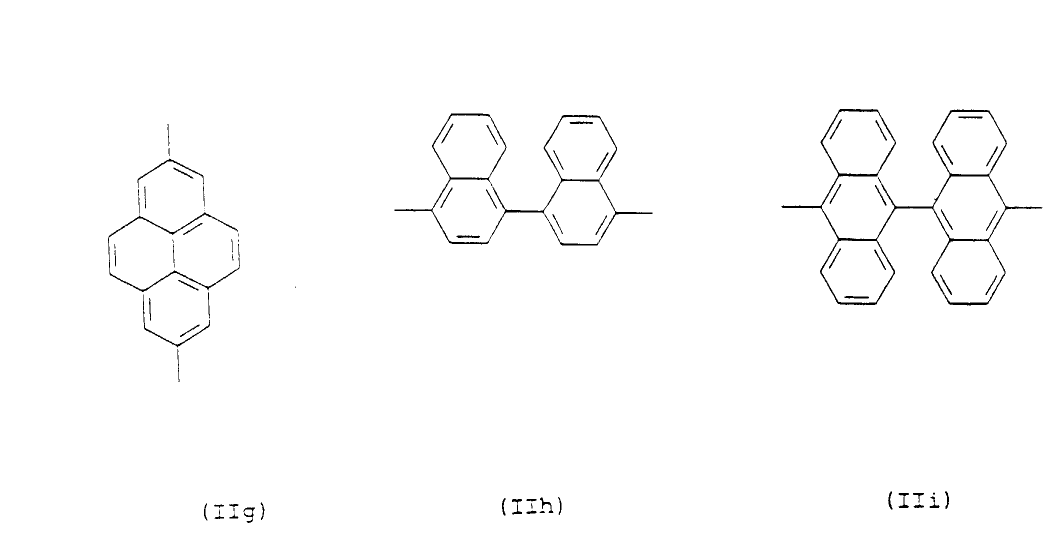 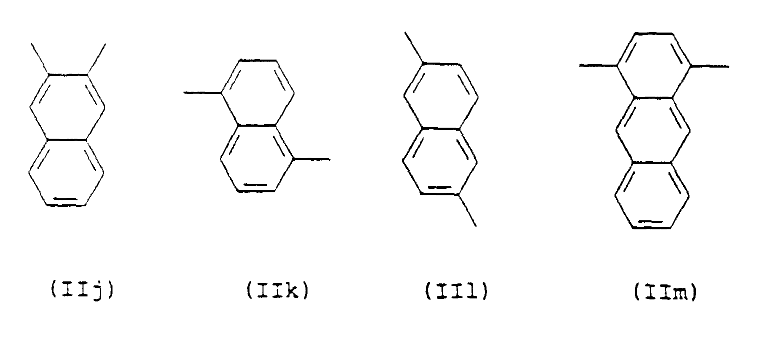 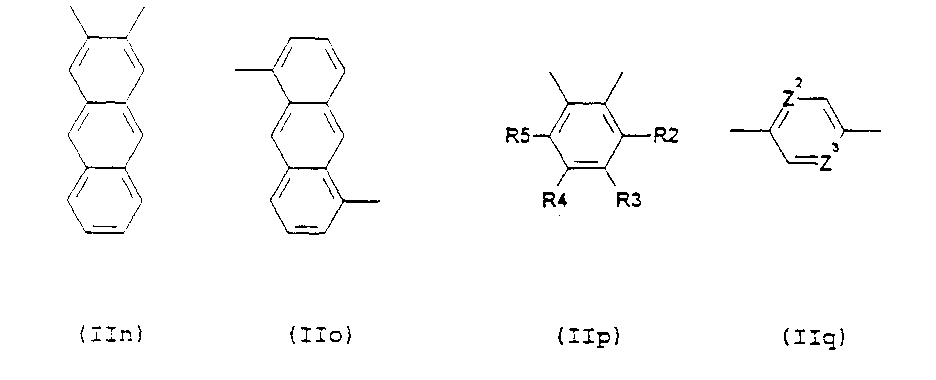 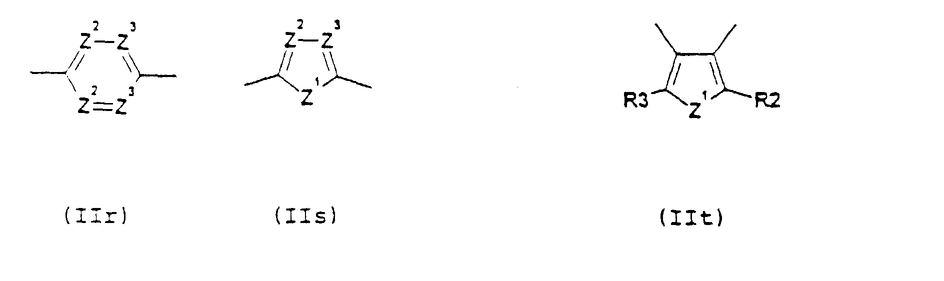 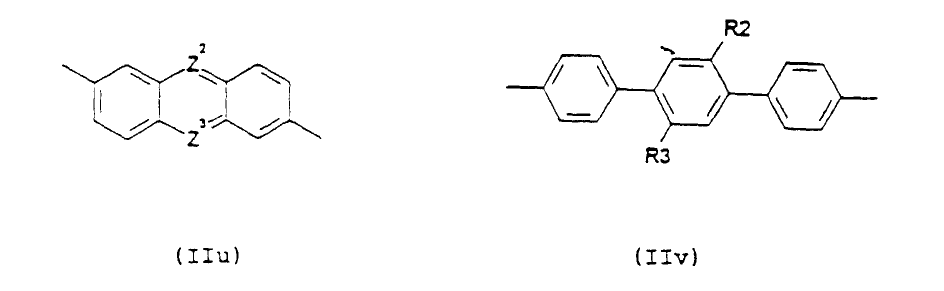 worin die Symbole Z¹, Z², 2³, R², R³, R⁴, R⁵, die in Formel (I) in Anspruch 5 angegebene Bedeutung haben.

7. Polymer, enthaltend Struktureinheiten gemäß mindestens einer der Formeln (Ia) bis (Ij) in Anspruch 5 und Struktureinheiten gemäß mindestens einer der Formeln (IIa) bis (IIv) in Anspruch 6.

8. Polymer, enthaltend Chromophorsegmente der Formel (Ia) in Anspruch 5 und Spacersegmente gemäß mindestens einer der Formeln (IIa) bis (IIe) in Anspruch 6.

9. Polymer, enthaltend Chromophorsegmente der Formel (Ia) in Anspruch 5 und Spacersegmente gemäß mindestens einer der Formeln (IIa) bis (IIc) in Anspruch 6.

10. Elektrooptische Schalt- und Anzeigevorrichtung, enthaltend ein Polymer, welches konjugativ verknüpfte Chromophor- und Spacersegmente enthält, wobei die Absorption der Spacersegmente mindestens 25 nm kürzerwellig als die der Chromophorsegmente ist und wobei die Emissionseigenschaften des Polymers und dessen Emissionseigenschaften durch die Emissionseigenschaften der einzelnen Chromophorsegmente bestimmt wird.

## Claims

1. Use in electrooptical switching and display devices of a copolymer comprising conjugatively linked chromophore and spacer segments, where the absorption of the spacer segments is at least 25 nm shorter in wavelength than that of the chromophore segments and the emission properties of the polymer are determined by the emission properties of the individual chromophore segments.

2. Use as claimed in claim 1, wherein individual segments of the polymer are twisted with respect to one another.

3. Use as claimed in claim 1 or 2, wherein the angle of twist is from 10° to 170°.

4. Use as claimed in one or more of claims 1 to 3, wherein the polymer has alternating chromophore and spacer groups.

5. Use as claimed in one or more of claims 1 to 4, wherein the polymer comprises chromophore segments having at least one of the formulae (Ia) to (Ij): 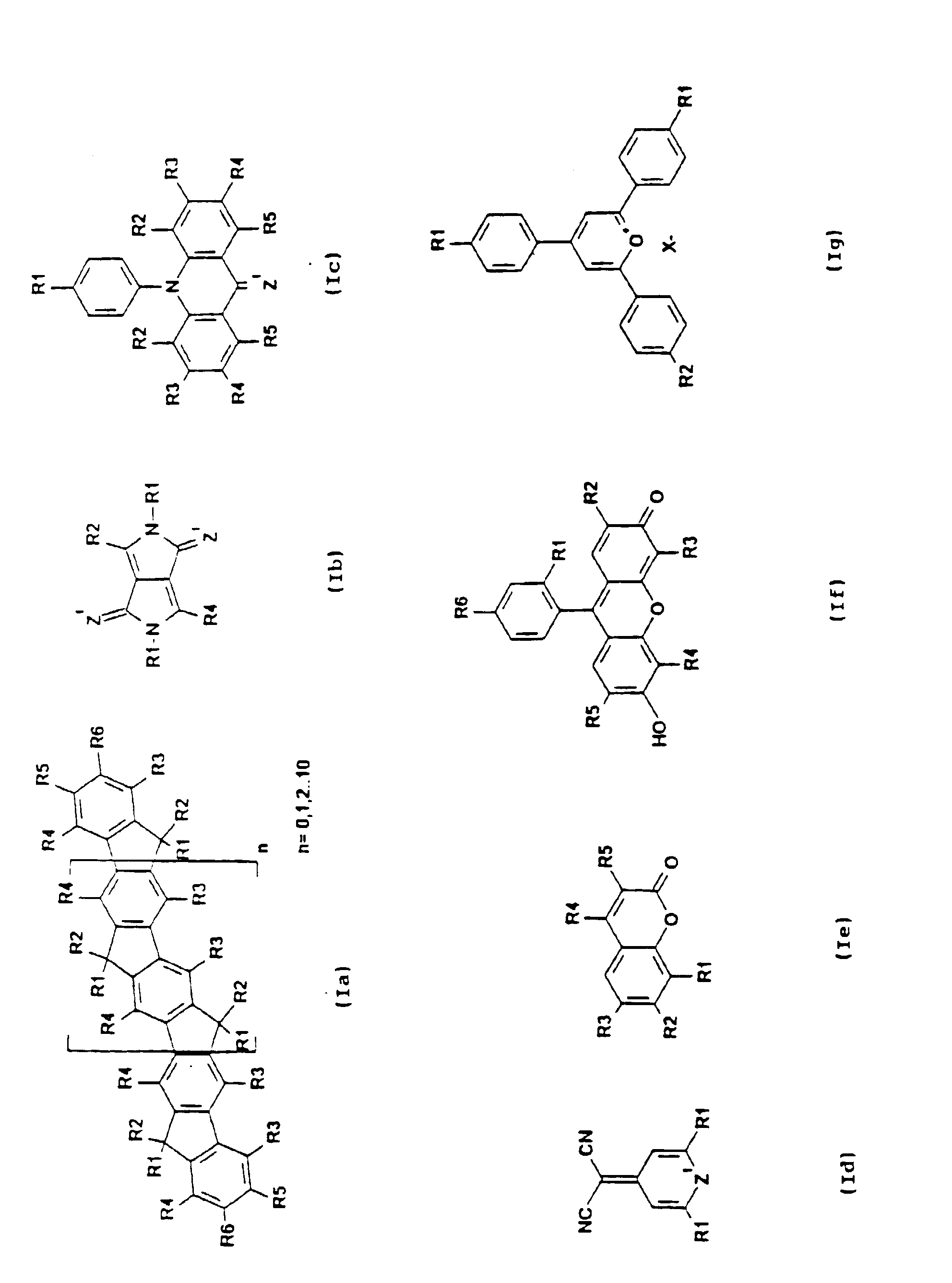 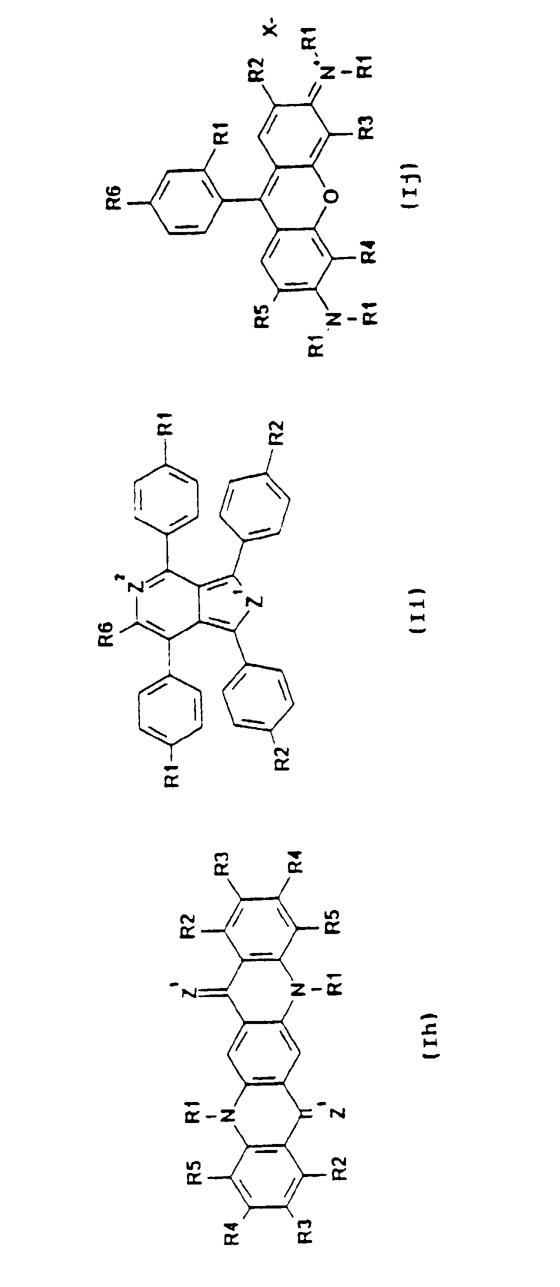 where:
R¹ is H, a straight-chain or branched alkyl group having from 1 to 22 carbon atoms, a C₆-C₁₀-aryl group or the linkage point to the adjacent spacer segment, with the linkage having to be such that the conjugation is maintained;
R², R³, R⁴, R⁵, R⁶ are identical or different and are each as defined for R¹ or a straight-chain or branched alkoxy group having from 1 to 22 carbon atoms, C₆-C₁₀-aryloxy, NR¹₂, NO₂, CN;
Z¹ is O, S, NR¹, CR²₂;
Z², Z³ are CR², N;
X⁻ is Cl^{⊖}, Br^{⊖}, I^{⊖}, BF^{⊖} ₄, PF^{⊖}₆, B(Ph)₄^{⊖};
n is 1, 2, 3, 4, 5.

6. Use as claimed in one or more of claims 1 to 5, wherein the polymer comprises spacer segments having at least one of the formulae (IIa) to (IIv): 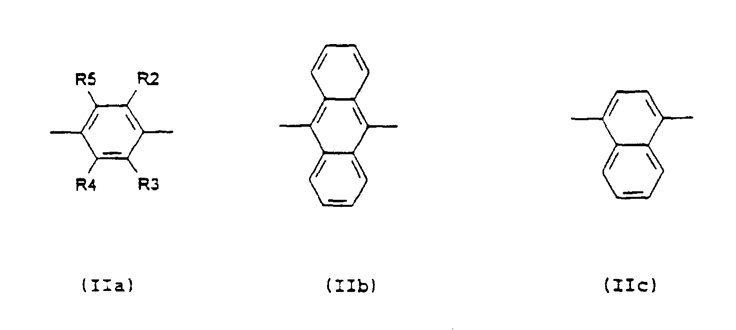 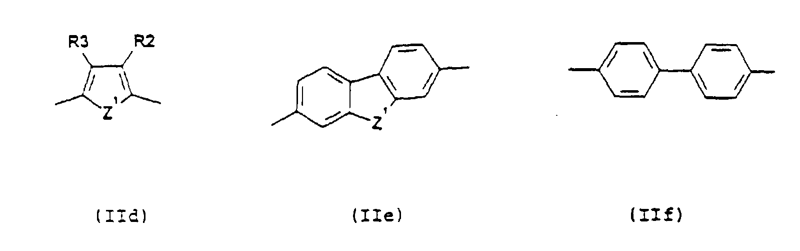 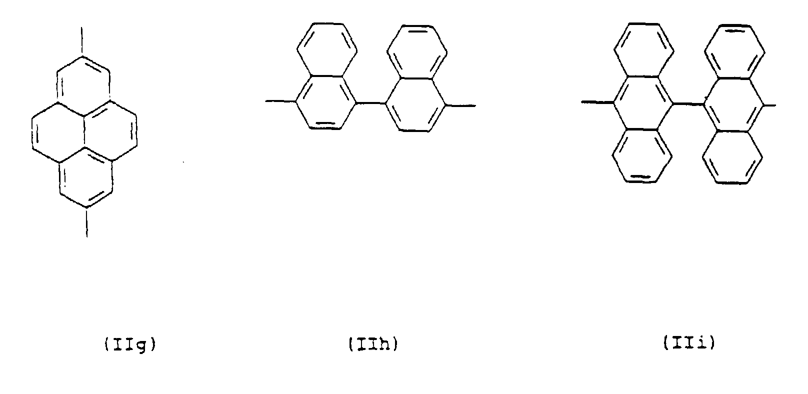 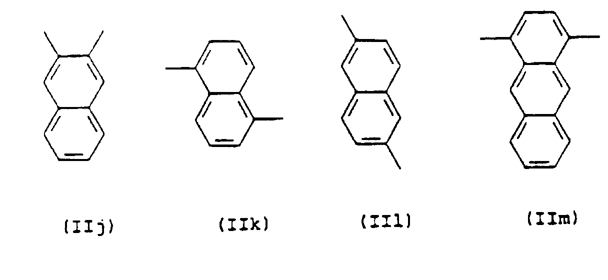 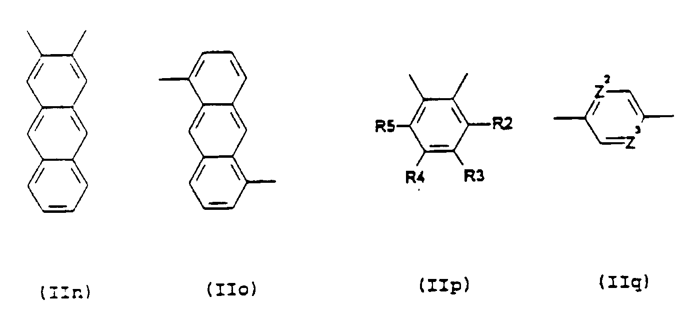 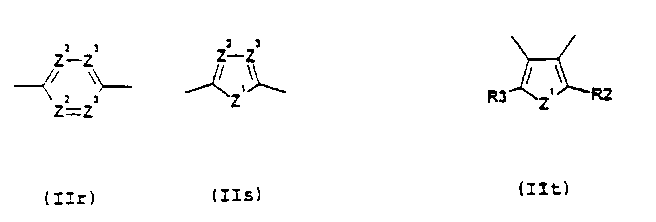 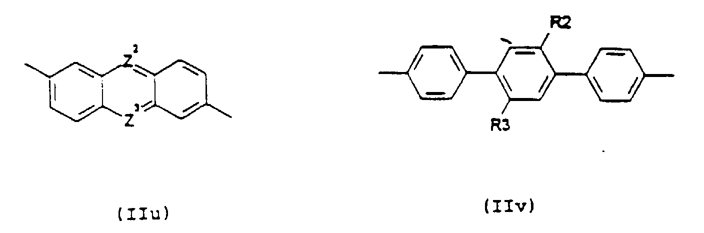 where the symbols Z¹, Z², Z³, R², R³, R⁴, R⁵ are as defined for formula (I) in claim 5.

7. A polymer comprising structural units having at least one of the formulae (Ia) to (Ij) in claim 5 and structural units having at least one of the formulae (IIa) to (IIv) in claim 6.

8. A polymer comprising chromophore segments of the formula (Ia) in claim 5 and spacer segments having at least one of the formulae (IIa) to (IIe) in claim 6.

9. A polymer comprising chromophore segments of the formula (Ia) in claim 5 and spacer segments having at least one of the formulae (IIa) to (IIc) in claim 6.

10. An electrooptical switching and display device comprising a polymer comprising conjugatively linked chromophore and spacer segments, where the absorption of the spacer segments is at least 25 nm shorter in wavelength than that of the chromophore segments and the emission properties of the polymer are determined by the emission properties of the individual chromophore segments.

## Revendications

1. Utilisation d'un copolymère, contenant des segments chromophores et d'espacement couplés de manière conjuguée, dans lequel l'absorption des segments d'espacement a une longueur d'onde plus courte que celle des segments chromophores d'au moins 25 nm et dans lequel les caractéristiques d'émission du polymère sont déterminées par les caractéristiques d'émission des segments chromophores individuels, dans des dispositifs de commutation et de signalisation électrooptiques.

2. Utilisation selon la revendication 1, caractérisée en ce que des segments individuels du polymère sont torsadés les uns contre les autres.

3. Utilisation selon la revendication 1 ou 2, caractérisée en ce que l'angle de torsion est de 10° à 170°.

4. Utilisation selon une ou plusieurs des revendications 1 à 3, caractérisée en ce que le polymère présente une suite alternée de groupes chromophores et de groupes d'espacement.

5. Utilisation selon une ou plusieurs des revendications 1 à 4, caractérisée en ce que le polymère contient des segments chromophores selon au moins l'une des formules (Ia) à (Ij) : 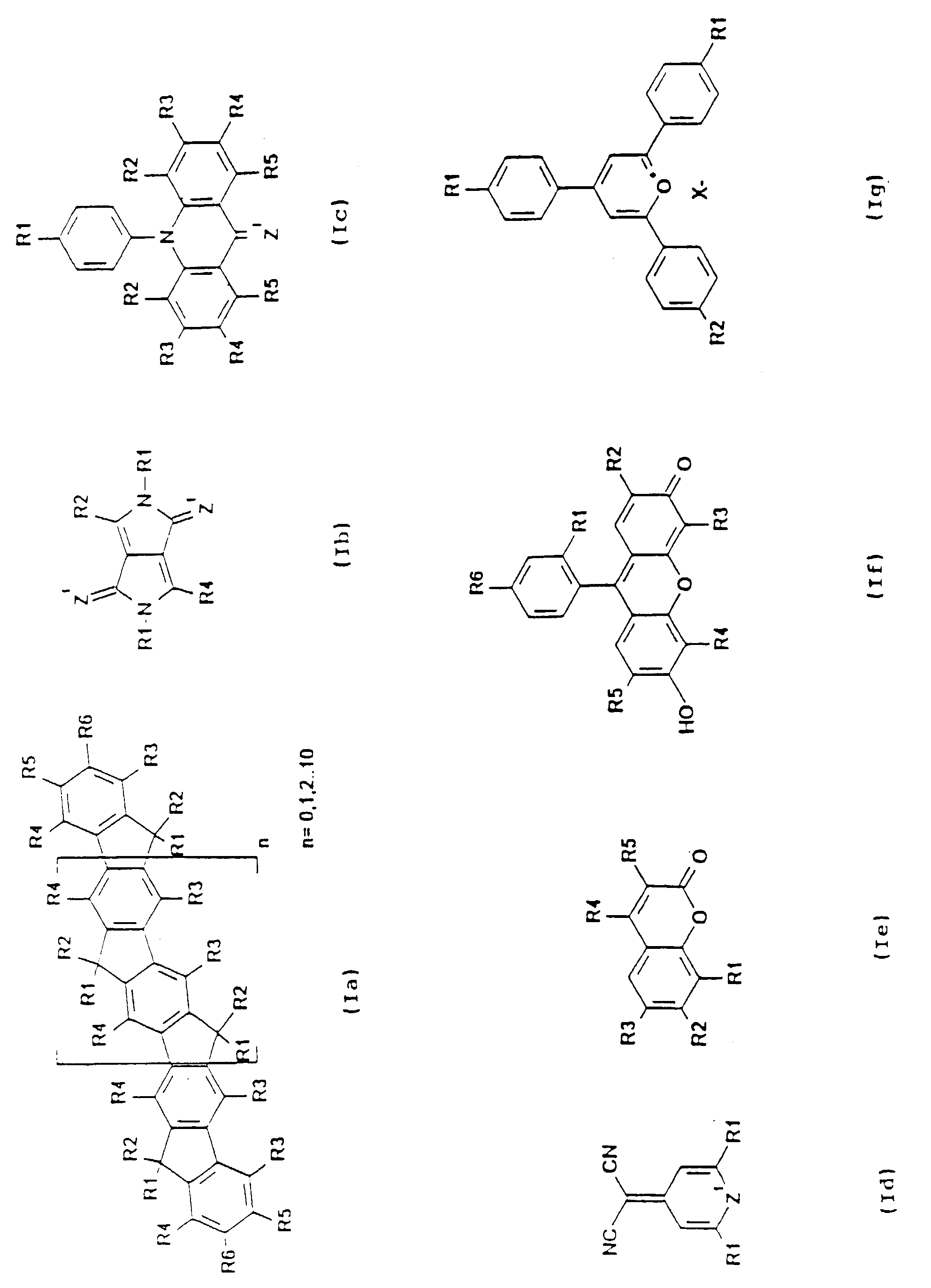 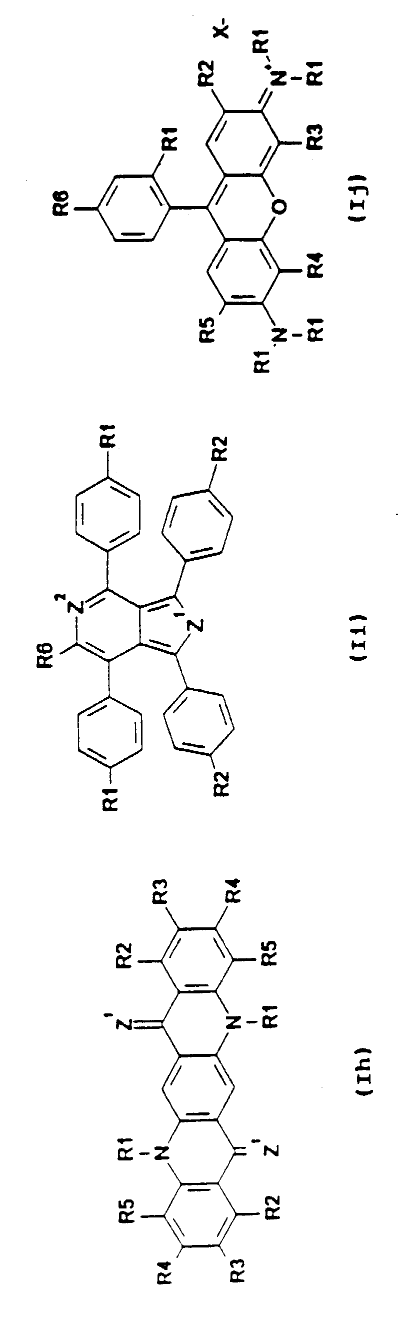 formules dans lesquelles les symboles signifient :
R¹ un atome d'hydrogène, un groupe alkyle linéaire ou ramifié avec 1 à 22 atomes de carbone, un groupe aryle en C₆-C₁₀ ou la position de couplage avec le segment espaceur voisin, le couplage devant être tel que la conjugaison reste conservée;
R², R³, R⁴, R⁵, R⁶, identiques ou différents de R¹, un groupe alkoxy linéaire ou ramifié avec 1 à 22 atomes de carbone, aryloxy en C₆-C₁₀, NR¹₂, NO₂, CN;
Z¹ O, S, NR¹, CR²₂;
Z², Z³ CR², N;
X Cl⁻, Br⁻, I⁻, BF⁻₄, PF⁻₆, B(Ph)₄⁻;
n 1, 2, 3, 4, 5.

6. Utilisation selon une ou plusieurs des revendications 1 à 5, caractérisée en ce que le polymère contient des segments espaceurs selon au moins l'une des formules (IIa) à (IIv) : 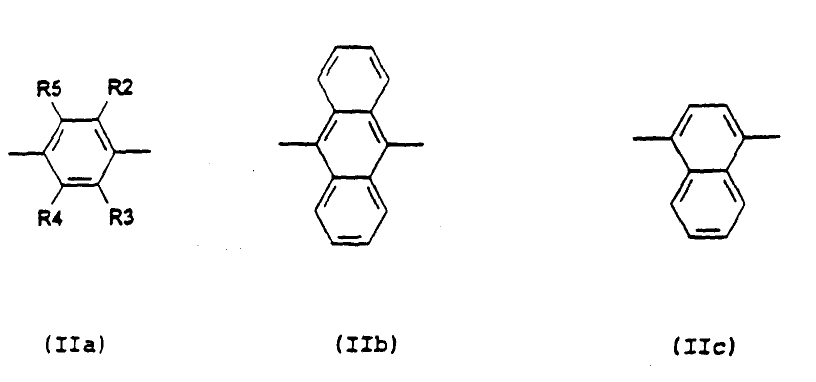 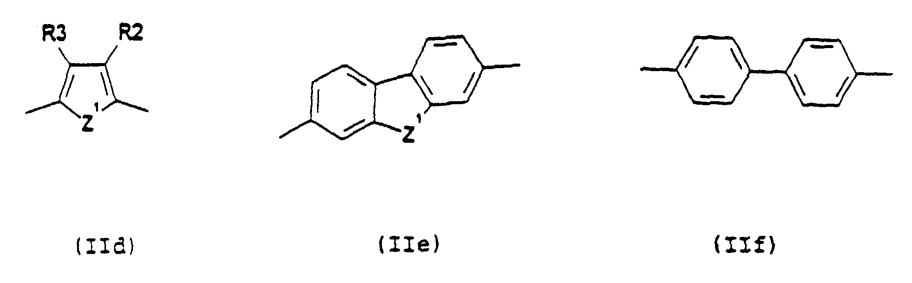 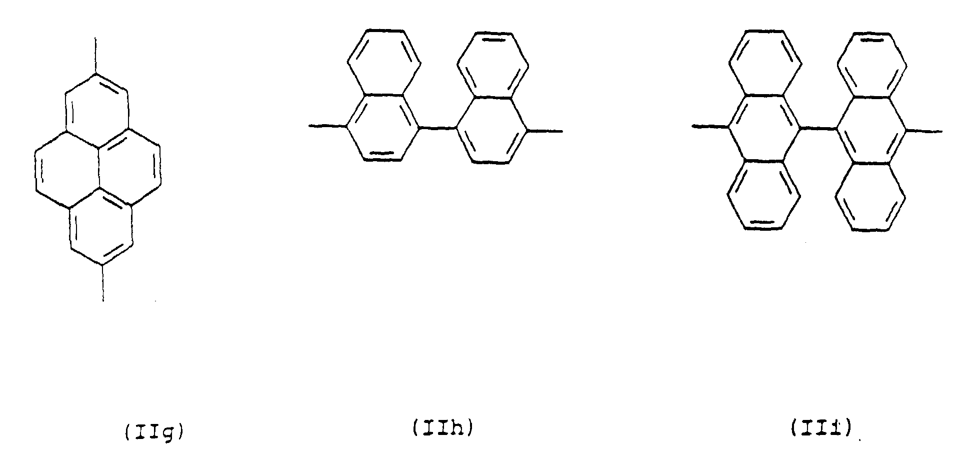 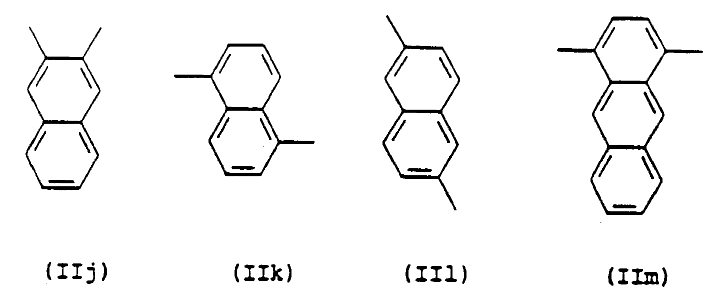 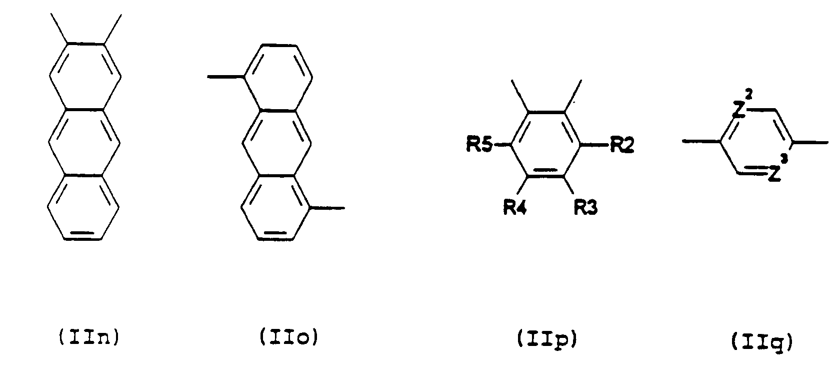 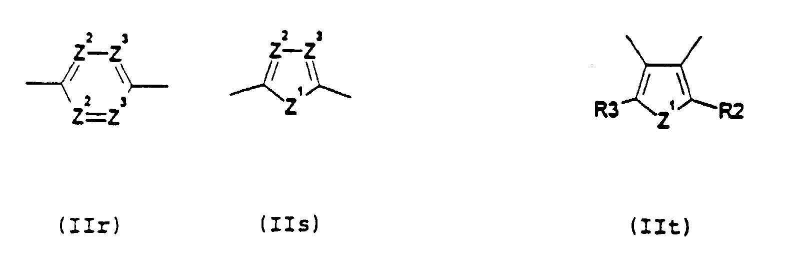 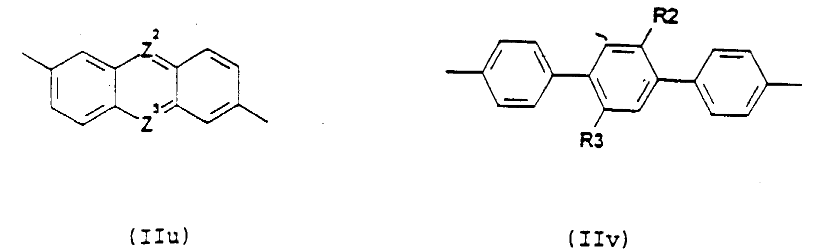 formules dans lesquelles Z¹, Z², Z³, R², R³, R⁴, R⁵ ont les significations données dans la formule (I) de la revendication 5.

7. Polymère, contenant des motifs de structure selon au moins une des formules (Ia) à (Ij) de la revendication 5 et des motifs de structure selon au moins une des formules (IIa) à (IIv) de la revendication 6.

8. Polymère, contenant des segments chromophores de formule (la) de la revendication 5 et des segments espaceurs selon au moins une des formules (IIa) à (IIe) de la revendication 6.

9. Polymère, contenant des segments chromophores de formule (la) de la revendication 5 et des segments espaceurs selon au moins une des formules (IIa) à (IIc) de la revendication 6.

10. Dispositif de commutation et de signalisation électrooptique, contenant un polymère, qui contient des segments chromophores et des segments espaceurs couplés de manière conjuguée, dans lequel l'absorption des segments d'espacement a une longueur d'onde plus courte que celle des segments chromophores d'au moins 25 nm et dans lequel les caractéristiques d'émission du polymère sont déterminées par les caractéristiques d'émission des segments chromophores individuels.
